(19) Europäisches Patentamt
European Patent Office
Office européen des brevets

(11) **EP 4 428 780 A1**

(12) **EUROPEAN PATENT APPLICATION**
published in accordance with Art. 153(4) EPC

(43) Date of publication:
**11.09.2024 Bulletin 2024/37**

(21) Application number: **22889195.8**

(22) Date of filing: **28.10.2022**

(51) International Patent Classification (IPC):
**G06Q 10/06** (2023.01)  **G06N 3/08** (2023.01)
**G06N 3/04** (2023.01)  **G06F 30/27** (2020.01)
**H01L 21/67** (2006.01)

(86) International application number:
**PCT/CN2022/128199**

(87) International publication number:
**WO 2023/078170 (11.05.2023 Gazette 2023/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **04.11.2021 CN 202111302143**

(71) Applicant: **Beijing NAURA Microelectronics
Equipment Co., Ltd.
Beijing 100176 (CN)**

(72) Inventor: **LIN, Yuanwei
Beijing 100176 (CN)**

(74) Representative: **Cohausz & Florack
Patent- & Rechtsanwälte
Partnerschaftsgesellschaft mbB
Bleichstraße 14
40211 Düsseldorf (DE)**

(54) **SEMICONDUCTOR PROCESS FORMULA ACQUISITION METHOD AND SYSTEM AND SEMICONDUCTOR PROCESS DEVICE**

(57) A semiconductor process recipe automatic acquisition method and system and semiconductor process equipment. The method includes randomly inputting a process parameter set into a constructed deep neural network model, determining whether a difference degree between a process result evaluation index output by the deep neural network model and a corresponding set process requirement meets a set requirement, if yes, using the process parameter set as a process recipe for an actual process, and otherwise, using a gradient algorithm to adjust the process parameters input into the deep neural network model, obtaining, based on a self-consistent iterative method, a process parameter set that makes all process result evaluation indices output by the deep neural network model satisfy the correspondingly set process requirements, and using the process parameter set as the process recipe for the actual process. The corresponding process recipe is automatically obtained according to the provided process requirements, and the acquisition efficiency of the process recipe is improved.

FIG. 3A

**Description**

**TECHNICAL FIELD**

The present disclosure generally relates to the semiconductor manufacturing technology field and, more particularly, to a semiconductor process recipe acquisition method, a semiconductor process recipe acquisition system, and semiconductor process equipment.

**BACKGROUND**

In the field of microelectronics manufacturing, plasma etching is a critical process in device fabrication. For example, in discrete transistor devices, trench gates are etched to suppress short-channel effects and address a problem such as mobility reduction caused by channel electron scattering. Thus, the discrete transistor devices are transitioning from traditional planar gates to trench gates and are applicable to both silicon-based and silicon carbide-based Metal-Oxide-Semiconductor Field-Effect Transistor (MOSFET) devices. Additionally, by etching super junctions in the discrete transistor devices, on-resistance can be effectively reduced, and a device switching speed can be enhanced. Since a drive current of a lateral super junction is small, mainstream products in the market adopt super junctions with a vertical structure. The process technology is developed from multiple times of epitaxial process to a deep trench process. Thus, deep silicon etching is needed. Moreover, in High Electron Mobility Transistor (HEMT) devices of gallium nitride, a method to realize a normally-off device includes etching a gate recess at the gate. Surface state energy levels of gallium nitride are changed by the gate recess to realize the device to be normally-off. For the discrete devices that originally need trench etching, the process is also developed toward high depth and width radio and high verticality. For example, in the traditional silicon capacitor device, when the trench is deeper, the device space can be more effectively used to improve the capacitance. When the verticality is higher, the actual device is closer to the theoretical model, and the design needs are better satisfied. For another example, in advanced packaging, the device performance can be improved, the power consumption can be lowered, and the size of the device can be reduced by etching a through silicon vias (TSV) structure.

Thus, with the development in the semiconductor discrete devices and the advanced packaging fields, higher and higher requirements are imposed on deep silicon etching. Since the silicon deep microstructure has a large depth and width ratio and high verticality, it is difficult for traditional wet etching to finish the silicon deep microstructure, which must be obtained in a dry etching method. To obtain the silicon microstructure with a large depth and a vertical angle, a dry etching process with isolated time can be adopted, i.e., the Bosch process. In the process, the plasma is used to induce fluorocarbon polymer to provide sidewall passivation protection and downward etching the silicon through fluorine-based plasma chemical reactions. The sidewall passivation protection (deposition step) and fluorine-based plasma chemical reaction (etching step) alternate during the process. Since the deposition and etching are performed alternatively in the Bosch process, shell-like structures are inevitably formed, which leads to significant sidewall roughness.

Typically, the shell size at the top of deep silicon structures is the largest, with the roughest sidewalls, exhibiting noticeable shells and lateral wrinkles. Therefore, methods need to be provided to reduce the roughness at the top of the deep silicon structure. In addition to considering the sidewall roughness, the etch morphology (an angle of the sidewall). After the deep silicon structure is formed, it is difficult for the plasma to drill into the deep silicone structure. The product after etching can be difficult to remove from the deep silicon structure to form deep silicon structures large at the top and small at the bottom. Then, the process parameter can be adjusted to improve the average free path of the plasma and aid the plasma to move towards the wafer. Additionally, etching depth, etching rate, selective ratio to the mask, etc., can be used as indications to rate the etching effect of the deep silicon etching effect. To obtain a good deep silicon etching effect, the process parameter needs to be ire. That is, the process recipe can be adjusted. Currently, various recipes are tried manually by the process user. Thus, whether the recipe of the process requirements is satisfied can be determined. The process can be very complex and low-efficiency and cannot be automated.

**SUMMARY**

The present disclosure is intended to provide a semiconductor process recipe acquisition method and system, and semiconductor equipment to automatically obtain the corresponding process recipe according to the given process requirement to improve the acquisition efficiency for the process recipe.

To realize the above purpose, the present disclosure provides a semiconductor process recipe acquisition method, including:

randomly inputting a process parameter set required for a process into a constructed deep neural network model to obtain process result evaluation indices corresponding to the process parameter set, the process parameter set including a plurality of process parameters, the deep neural network model being a trained multi-layer deep neural network, the deep neural network model including an input layer, at least one intermediate layer, and an output layer, the input layer being configured to input the process parameter set, and the output layer being configured to output the process evaluation indices corresponding to the process parameter set;

determining whether a difference degree between the process evaluation indices and corresponding set process requirements meets set requirements;

if yes, using the process parameter set as the process recipe to perform an actual process; and

otherwise, according to the process requirements, along a direction from the output layer to the input layer, based on a gradient algorithm and a self-consistent iteration method, optimizing feature values of the at least one intermediate layer and values of the process parameters in the input layer layer by layer to optimize the values of characteristics in each middle layer and the values of each process parameter in the input layer layer by layer, until obtaining a process parameter set in the input layer that satisfies all process result evaluation indices output by the deep neural network model and meets the process requirements, and using the process parameter set that meets the process requirements as the process recipe to perform the actual process.

In some embodiments, a method for constructing the deep neural network model includes:

determining a number of layers and a structure of the deep neural network model according to a number of process parameters included in the process parameter set and a number of process result evaluation indices corresponding to the process parameter set; a number of the intermediate layers is a difference between the number of process parameters and the number of process result evaluation indices, and each deep neural network layer of the deep neural network model including a plurality of neurons, along the direction from the input layer to the output layer, one neuron being reduced sequentially between neighboring deep neural networks, each neuron being connected to all neurons in a previous deep neural network layer, each process parameter being used as an input feature of a neuron in the input layer, each neuron of the intermediate layer being configured to perform calculation on output features of all neurons in a previous deep neural network layer, an output feature of each neuron in the output layer being a process result evaluation index, and the number of the process parameters included in the process parameter set being greater than the number of the process result evaluation indices corresponding to the processing parameter set; and

determining an activation function for running the deep neural network model according to a number of layers of the deep neural network model.

In some embodiments, the method for constructing the deep neural network model further includes:

using a process database as training data and training the deep neural network model using a deep learning method, the process database including historical process parameter data and historical process result data of a specific process; and

determining a weight item and a bias item of each deep neural network layer of the deep neural network model according to a training result of the activation function.

In some embodiments, optimizing the feature values of the at least one intermediate layer and the values of the process parameters of the input layer based layer by layer on the gradient algorithm and the self-consistent iteration method includes:

step S1, finding a process result evaluation index having a largest difference degree with the process requirement in the output layer;

step S2, finding a process parameter with a largest value in the weight item related to the process result evaluation index having the largest difference degree from an intermediate layer neighboring to the output layer;

step S3, keeping a value of the weight item and a value of the bias item of the process parameter with the largest value in the weight item unchanged, using a gradient algorithm to optimize and step-adjust a feature value of the process parameter having the largest value in the weight item until a difference degree between the process result evaluation index having the largest difference degree in the output layer and the process requirement meets the set requirement;

step 4, if another process result evaluation index having a difference degree with the process requirement not meeting the set requirement exists in other process result evaluation indices, repeating step S1 to step S3 until all the process result evaluation indices in the output layer meet the process requirement, and determining a feature value of each process parameter in the intermediate layers; and

step S5, based on the feature value of each process parameter in the intermediate layer obtained in step S4, along a direction from the output layer to the input layer, continuing to use the gradient algorithm and self-consistence iteration method to optimize the feature value of each process parameter in other intermediate layers and the values of the process parameters in the input layer layer by layer, until a process parameter set causing all the process result evaluation indices output by the deep neural network model to meet the process requirement is obtained in the input layer.

In some embodiments, the semiconductor process recipe acquisition method further includes, after step S3, determining whether a difference degree between the adjusted process result evaluation index through step S3 and the process requirement meets the set requirement, if yes, performing step S4, and if not, keeping the process parameter with the largest value in the weight item adjusted and optimized through step S3 and performing the following steps:

step S6, finding a process parameter with a second largest value in the weight item related to the process result evaluation index adjusted in step S3 from the intermediate layer neighboring to the output layer; and
step S7, keeping the value of the weight item of the process parameter having the second largest value in the weight item unchanged, and using the gradient algorithm to optimize and step-adjust a feature value of the process parameter having the second largest value in the weight item, until a difference degree between the process result evaluation index correspondingly adjusted in step S3 in the output layer and the process requirement meets the set requirement.

In some embodiments, the semiconductor process recipe acquisition method further includes, after step 5:

step S8, if a process result evaluation index having a different degree with the process requirement not meeting the set requirement still exists in the output layer after optimizing and adjusting all the process parameters related to the process result evaluation indices,
selecting process parameters that causes a sum of squares of difference degrees between the process result evaluation indices and the process requirements to form a new process parameter set, and using the new process parameter set as a process recipe for performing an actual process.

In some embodiments, a calculation equation of the gradient algorithm is:

$$x_i = x_i - \theta \times (\partial y / \partial x_i),$$

where $x_i$ denotes the adjusted process parameter in the intermediate layer, y denotes the adjusted process result evaluation index, and $\theta$ denotes an adjustment step size.

In some embodiments, the difference degree is calculated by:

$$\Delta = |(y - y_{actual}) / y_{actual}|,$$

wherein:

$\Delta$ denotes the difference degree between the process result evaluation index and the set process requirement, y denotes the process result evaluation index output by the deep neural network model, and $y_{actual}$ denotes the given process requirement; and
the set requirement includes the difference degree between the process result evaluation index and the corresponding set process requirement ranging between 0 and 10%.

As a second aspect, the present disclosure further provides a semiconductor process recipe automatic acquisition method, including:

a deep neural network model, the deep neural network model being a multi-layer structured deep neural network that has been trained, the deep neural network model outputting accurate process result evaluation indices corresponding to a process parameter set based on input process parameters; and
a calculation module configured to perform the semiconductor process recipe acquisition method according to any one of claims 1 to 8.

As a second aspect, the present disclosure further provides semiconductor process equipment, including the semiconductor process recipe automatic acquisition system according to claim 9.

The beneficial effects of the present disclosure are as follows.

In the present disclosure with the given process requirement, based on the constructed deep neural network model, and according to the set process requirement, along the direction from the output layer to the input layer, the gradient algorithm and the self-consistent iteration method can be used to optimize and adjust the feature values of the intermediate layer and the process parameter set of the input layer layer by layer, until the process parameter set that causes all the process result evaluation indices output by the deep neural network model meet the process requirement is reverse-engineered and used as the process recipe of the actual process. Compared to the existing method in which an operator repeatedly adjusts the process recipe parameters, in the present disclosure, the process recipe parameters satisfying the process requirement can be automatically provided by the deep neural network model according to the process requirement, which improves the acquisition efficiency of the process recipe and increases the automation degree of the etching machine.

The system of the present disclosure includes other features and advantages. These features and advantages are obvious from the accompanying drawings and the specific embodiments or are described in detail in the accompanying drawings and the specific embodiments. These accompanying drawings and the specific embodiments are used to explain the principle of the present disclosure.

## BRIEF DESCRIPTION OF THE DRAWINGS

Embodiments of the present disclosure are described in more detail in connection with the accompanying drawings. The above or other purposes, features, and advantages of the present disclosure become more obvious. In embodiments of the present disclosure, same reference numerals can represent a same component.

FIG. 1 illustrates a schematic diagram of a deep neural network model applied to a lithography of the existing technology one.

FIG. 2 illustrates a schematic diagram of a neural network model for predicting an etching process result of the existing technology three.

FIG. 3A illustrates a schematic flowchart of a semiconductor process recipe acquisition method according to some embodiments of the present disclosure.

FIG. 3B illustrates another schematic flowchart of a semiconductor process recipe acquisition method according to some embodiments of the present disclosure.

FIG. 3C illustrates another schematic flowchart of a semiconductor process recipe acquisition method according to some embodiments of the present disclosure.

FIG. 3D illustrates another schematic flowchart of a semiconductor process recipe acquisition method according to some embodiments of the present disclosure.

FIG. 4 illustrates a schematic diagram of a deep neural network model in a semiconductor process recipe acquisition method according to a second embodiment of the present disclosure.

FIG. 5 illustrates a schematic diagram showing an etching process with a feature size of 3 micrometers in the semiconductor process recipe acquisition method according to some embodiments of the present disclosure.

FIG. 6 illustrates a schematic diagram showing an impact of a chamber pressure on a rating index of a groove etching process result in a semiconductor process recipe acquisition method according to some embodiments of the present disclosure.

FIG. 7 illustrates a schematic diagram showing an impact of an electrode end power under an etching step on a rating index of a groove etching process result in a semiconductor process recipe acquisition method according to some embodiments of the present disclosure.

FIG. 8 illustrates a schematic diagram showing an impact of an end time of an etching step on a rating index of a groove etching process result in a semiconductor process recipe acquisition method according to some embodiments of the present disclosure.

FIG. 9 illustrates a schematic diagram showing an impact of an end time of a deposition step on a rating index of a groove etching process result in a semiconductor process recipe acquisition method according to some embodiments of the present disclosure.

FIG. 10 illustrates a schematic diagram showing an impact of an $SF_6$ gas of an etching step on a rating index of a groove etching process result in a semiconductor process recipe acquisition method according to some embodiments of the present disclosure.

FIG. 11 illustrates a schematic diagram showing an impact of a $C_4F_8$ gas of a deposition step on a rating index of a groove etching process result in a semiconductor process recipe acquisition method according to some embodiments of the present disclosure.

FIG. 12 illustrates SEM diagrams of groove etching process requirements in a semiconductor process recipe acquisition method according to some embodiments of the present disclosure.

FIG. 13 illustrates a schematic diagram showing an impact of a chamber pressure on a rating index of a hole etching process result in a semiconductor process recipe acquisition method according to some embodiments of the present disclosure.

FIG. 14 illustrates a schematic diagram showing an impact of an electrode end power of an etching step on a rating index of a hole etching process result in a semiconductor process recipe acquisition method according to some embodiments of the present disclosure.

FIG. 15 illustrates a schematic diagram showing an impact of an end time of an etching step on a rating index of a hole etching process result in a semiconductor process recipe acquisition method according to some embodiments of the present disclosure.

FIG. 16 illustrates a schematic diagram showing an impact of an end time of a deposition step on a rating index of a hole etching process result in a semiconductor process recipe acquisition method according to some embodiments of the present disclosure.

FIG. 17 illustrates a schematic diagram showing an impact of an $SF_6$ gas of an etching step on a rating index of a hole etching process result in a semiconductor process recipe acquisition method according to some embodiments of the present disclosure.

FIG. 18 illustrates a schematic diagram showing an impact of a $C_4F_8$ gas of a deposition step on a rating index of a hole etching process result in a semiconductor process recipe acquisition method according to some embodiments of the present disclosure.

FIG. 19 illustrates SEM diagrams of hole etching process requirements in a semiconductor process recipe acquisition method according to some embodiments of the present disclosure.

## DETAILED DESCRIPTION OF THE EMBODIMENTS

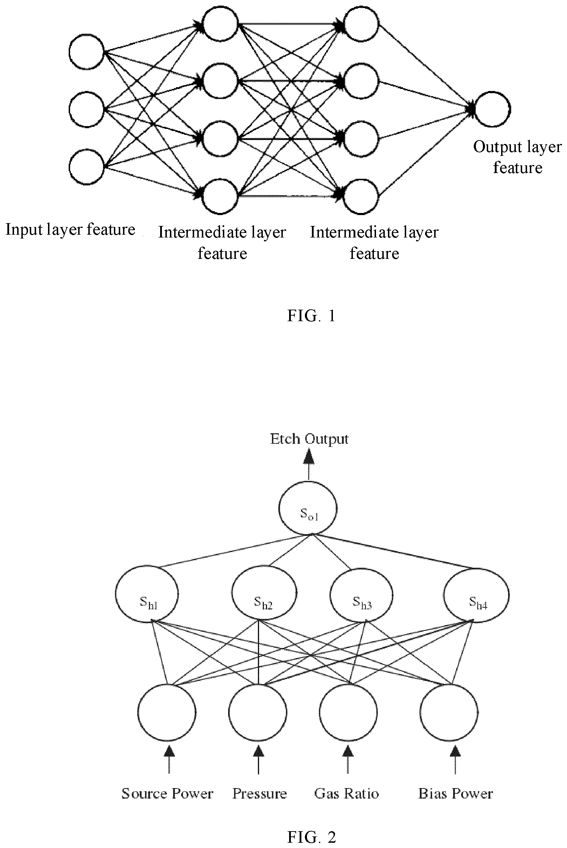

The existing technology one provides a deep neural network model applied in a photolithography machine. The deep neural network model is shown in FIG. 1. In the solution, based on the deep neural network model completing deep learning, a photolithography process result can be automatically output according to a photolithography process parameter input to the model.

The deep neural network model is the existing technology. In some embodiments, an activation function of the model needs to be defined. Linear conversion can be performed on parameters of an input layer $y=f(\sum_i w_i x_i+b)$. $x_i$ denotes an input feature, $w_i$ denotes weights of the features, and b denotes bias. This is the simplest case with a single-layer neural network. If a multi-layer neural network exists, the activation function for a two-layer model can be transformed into $y=g(\sum_j w_j f(\sum_i w_i x_i+ b1)+ b2)$. The activation function for a three-layer model can be transformed into $y=h(\sum_k w_k g(\sum_j w_j f(\sum_i wi x_i+ b1)+ b2)+ b3)$, and so on.

Then, a target function of $J(w_i, b)= (\sum_i w_i x_i+b- y_r)^2$ is defined according to a sum of squares of deviations between input and output values $(x_i, y)$ obtained using the activation function of the model and the actual dataset $(x_i, y_r)$. If n actual datasets $(x_{i,n}, y_{r,n})$ exist, the target function may need to be arithmetically averaged: $J(w_i, b)= (1/n) \sum_n (\sum_i w_i x_{i,n} +b- y_{r,n})^2$.

In the neural network model, data training is an important step and mainly involves parameter optimization. Currently, mainstream optimizers can include a stochastic gradient descent method, a momentum stochastic gradient descent method, and an Adam optimization method. Taking the stochastic gradient descent method as an example, the algorithm is $w_i = w_i -\eta \times [\partial J(w_i, b)/ \partial w_i]$, $b = b -\eta \times [\partial J(w_i, b)/ \partial b]$.

That is, partial derivative calculation is performed on the relevant parameters, and movement is performed each time according to the product of the step size $\eta$ and the partial derivative until the target function obtains the minimum value to be stabilized. That is, the deviation between the model predicted data and the actual data is minimum. For multi-layer neural networks, calculation can be reversed layer by layer to cause the target function of each layer to obtain the minimum value. That is, the deviations between the whole model predicted data and the actual value are minimum.

After research, the inventor finds the following problem in the existing technology one.

The neural network model can only provide forward learning and prediction. That is, the process result can be derived from the process parameter recipe in a forward manner. During the forward derivation, variables in the gradient optimization algorithm are the weights $w_i$, reverse derivation of obtaining the process parameters according to the process requirements cannot be realized. Moreover, the existing technology one does not involve machine automation.

Photolithography machines have high requirements for precision, and the algorithms of the optimizers are relatively complex. Other semiconductor process equipment such as etching machines can have some tolerance for precision relative to the computational process speed.

The existing technology two provides a self-consistent iterative method. That is, only numerical solutions can be obtained instead of analytical solutions when transcendental equations are solved. When the numerical solutions are calculated, a method of continuous iterative processes can be adopted until convergence to the optimal solution is achieved to form self-consistency.

If an operator in an equation is a function of unknown variables, only the self-consistent iterative method can be used. Initially, a set of assumed numerical values for the unknown variables is provided, and the operator is solved. The obtained operator is then substituted back into the original equation to obtain another set of numerical solutions for the unknown variables. This process repeats until the assumed numerical values of the unknown variables and the calculated values of the unknown variables are completely consistent, i.e., self-consistency. The method has been used in solving the Hartree-Fock equation in the field of quantum computing.

However, the method has not been applied to the neural network model or in the semiconductor process equipment field.

The existing technology three provides a neural network model for predicting etching process results shown in Figure 2. After research, the inventor found that the solution only uses a single-layer neural network model, which belongs to a regular neural network rather than a deep neural network. Moreover, the solution can only be used to predict etching process results and cannot reverse-engineer the process parameters through the etching process results.

In the present disclosure, a process recipe for performing relative processes (such as dry etching) can be automatically provided according to the actual process requirements using software algorithms. In practical applications, if a user needs to obtain a deep silicon structure with a specific etching depth, a sidewall angle, a sidewall roughness, and a selectivity ratio of the mask, and expects to achieve a specific etching rate, the process parameter recipe can be automatically provided through the solution of the present disclosure, e.g., a chamber pressure, power of upper and lower electrodes, a gas flow rate, and etching time.

The present disclosure is described in more detail with reference to the accompanying drawings. Although the accompanying drawings show some embodiments of the present disclosure, it should be understood that the present disclosure can be implemented in various forms and is not limited to the embodiments described here. On the contrary, the embodiments are provided to make the present disclosure more transparent and complete. Moreover, the scope of the present disclosure can be completely conveyed to those skilled in the art.

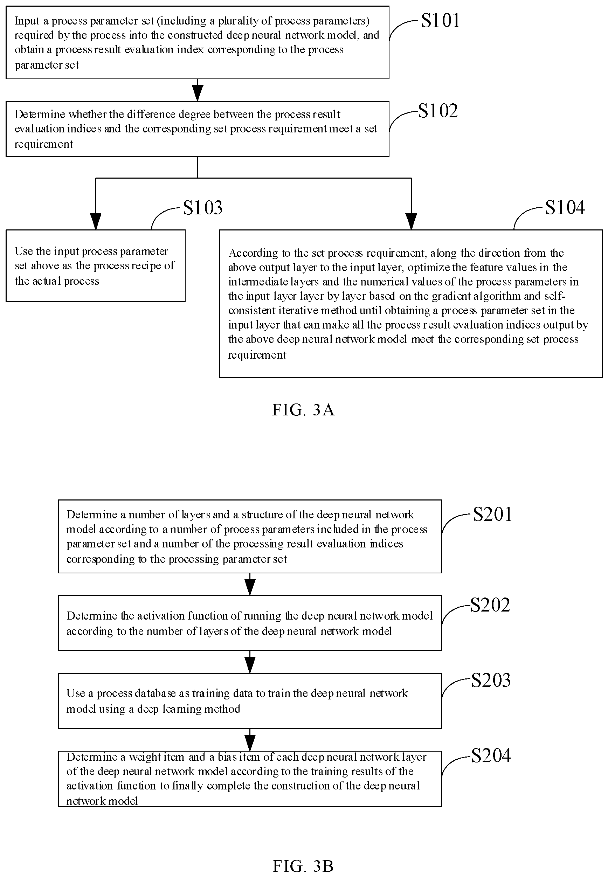

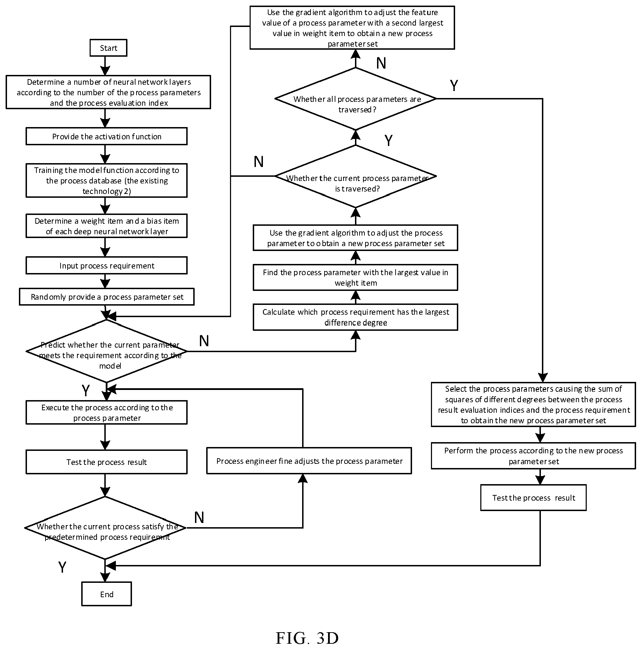

FIG. 3A to FIG. 3D illustrate several schematic flowcharts of steps of a semiconductor process recipe acquisition method according to some embodiments of the present disclosure. The semiconductor process recipe acquisition method includes the following steps.

At S101, a process parameter set (including a plurality of process parameters) required by the process is input into the constructed deep neural network model, and a process result evaluation index corresponding to the process parameter set is obtained.

The deep neural network model can be a trained multi-layer deep neural network. The deep neural network model can include an input layer, at least one intermediate layer, and an output layer. The input layer can be configured to input the process parameter set. The output layer can be configured to output the process result evaluation index corresponding to the process parameter set. That is, each layer of the input layer, the at least one intermediate layer, and the output layer can be a one-layer deep neural network.

In some embodiments, before step S101, the deep neural network model can be constructed first. As shown in FIG. 3B, a construction method of the deep neural network model includes the following steps.

At S201, a number of deep neural network layers and a structure of the deep neural network model are determined according to a number of process parameters included in the process parameter set and a number of the processing result evaluation indices corresponding to the processing parameter set.

The deep neural network model can include the input layer, the at least one intermediate layer, and the output layer. A number of intermediate layers can be the difference between the number of process parameters included in the process parameter set and the number of process result evaluation indices corresponding to the process parameter set. Each deep neural network layer of the deep neural network model can include a plurality of neurons. Along a direction from the input layer to the output layer, one neuron is successively reduced between neighboring deep neural networks. Each neuron can be connected to all neurons in a previous deep neural network layer. Each process parameter can be used as an input feature of a neuron in the input layer. Each neuron in the intermediate layer can be used to perform calculation on the output features of all neurons in the previous deep neural network layer. An output feature of each neuron in the output layer can be a corresponding process result evaluation index. The number of process parameters included in the process parameter set can be greater than the number of process result evaluation indices corresponding to the process parameter set.

At S202, the activation function of running the deep neural network model is determined according to the number of layers of the deep neural network model.

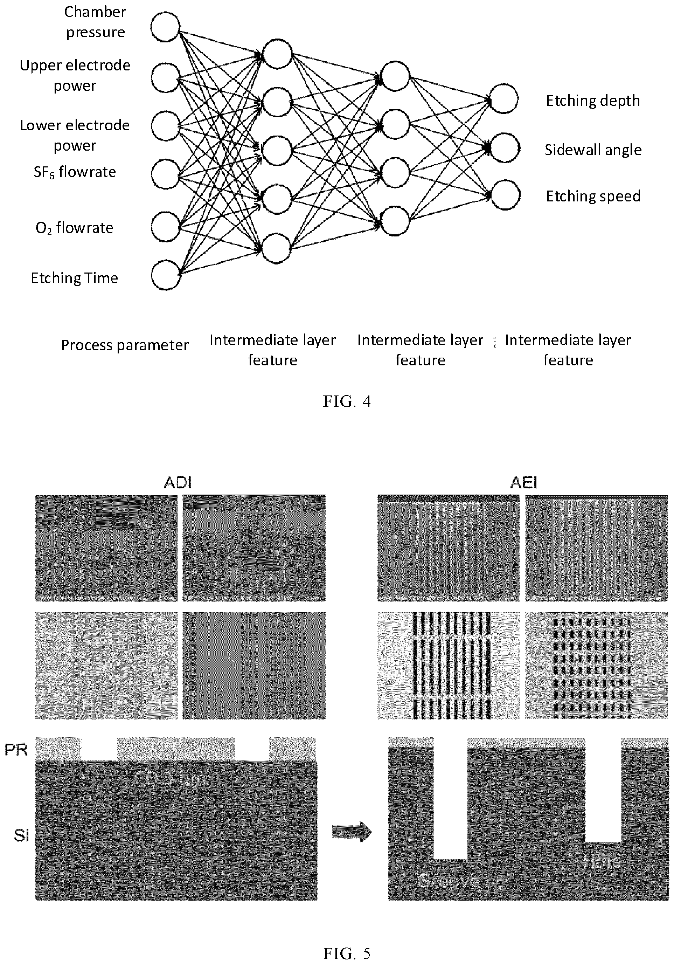

The deep neural network model of embodiments of the present disclosure is shown in FIG. 4. In some embodiments, the method for constructing the deep neural network model further includes the following steps.

At S203, a process database is used as training data to train the deep neural network model using a deep learning method.

The process database can include historical process parameter data and historical process result data for specific processes.

At S204, a weight item and a bias item of each deep neural network layer of the deep neural network model are determined according to the training results of the activation function to finally complete the construction of the deep neural network model.

In a specific implementation process, for a semiconductor process machine such as an etching machine, the number of process result evaluation indices is generally less than the number of process parameters. Therefore, based on the method for constructing the neural network model disclosed in existing technology one, the deep neural network model of the present disclosure can be constructed.

The number of layers of the neural network model can be determined by the difference between the number of input variables (the number of process parameters) and the number of output variables (the number of process result evaluation indices). One intermediate feature variable is subtracted between each two deep neural network layers shown in FIG. 4. Taking the etching machine for example, if the input process parameter set includes 6 process parameters, i.e., 6 variables, including chamber pressure, upper electrode power, lower electrode power, $SF_6$ flowrate, $O_2$ flowrate, and etching time. The process result corresponding to the process parameter set that is finally obtained can include three evaluation indices, including an etching depth, a sidewall angle, and an etching rate. Then, a deep neural network model (three deep neural network layers) with two layers of intermediate feature variables can be constructed.

The process parameters and process result databases obtained in routine work can be used for deep learning training of the model. An optimization algorithm similar to the existing technology one can be used to obtain the optimal model function $y=h(\sum_k w_k\, g(\sum_j w_j\, f(\sum_i w_i\, x_i+ b_1)+ b_2)+ b_3)$. That is, a model relationship between the process parameters and the process results can be obtained.

For practical problems, when the process results/process requirements are known, the optimal process recipe may need to be reverse-engineered. According to the deep neural network model of the present disclosure, the number of process result evaluation indices can be less than the number of process parameters in the process recipe. Therefore, the problem can be equivalent to solving an indeterminate equation. Theoretically, an infinite plurality of solutions can exist. To quickly find the optimal solution, a self-consistent iterative method can be adopted in the present disclosure.

At S102, whether the difference degree between the process result evaluation indices and the corresponding set process requirement meet a set requirement is determined.

At S103, if yes, the input process parameter set above is used as the process recipe of the actual process.

In some embodiments, in step S101 to step S103, a process parameter set (including a plurality of process parameters $x_i$) can be randomly provided as input features of the neurons in the input layer of the deep neural network model. Then, the process result evaluation index y output from the output layer of the deep neural network model can be compared with the actual process requirement y. If the difference degree meets the set requirement, the process parameter set can be used for the actual process.

The difference is calculated by the following equation:

$$\Delta = \left| (\,y - y\_{\text{actual}}) / \, y\_{\text{actual}} \right|$$

where $\Delta$ denotes the difference degree between the process result evaluation index and the set process requirement, y denotes the process result evaluation index output by the deep neural network model, and $y\_{\text{actual}}$ denotes the set process requirement.

In some embodiments, the set requirement includes the difference degree between the process result evaluation index and the corresponding set process requirement being between 0 and 10%, preferably 5%.

At S104, otherwise, according to the set process requirement, along the direction from the above output layer to the input layer, the feature values in the intermediate layers and the numerical values of the process parameters in the input layer are optimized layer by layer based on the gradient algorithm and self-consistent iterative method until obtaining a process parameter set in the input layer that can make all the process result evaluation indices output by the above deep neural network model meet the corresponding set process requirement. The process parameter set that meets the above process requirement as the process recipe for the actual process.

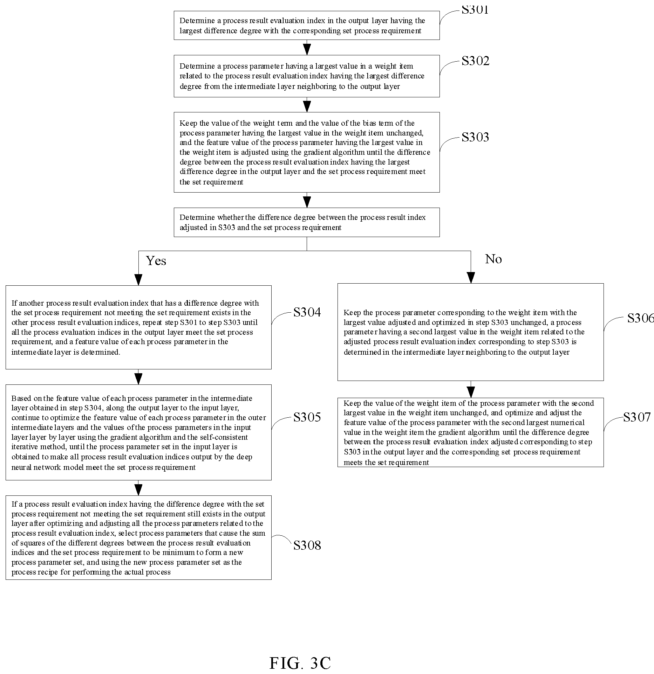

In some embodiments, as shown in FIG. 3C, based on the gradient algorithm and the self-consistent iterative method, optimizing the feature values in the intermediate layers and the numerical values of the process parameters in the input layer includes the following steps.

At S301, a process result evaluation index in the output layer having the largest difference degree with the corresponding set process requirement is determined.

At S302, a process parameter having a largest value in a weight item related to the process result evaluation index having the largest difference degree is determined from the intermediate layer neighboring to the output layer.

At S303, the value of the weight term and the value of the bias term of the process parameter having the largest value in the weight item are kept unchanged, and the feature value of the process parameter having the largest value in the weight item is adjusted using the gradient algorithm until the difference degree between the process result evaluation index having the largest difference degree in the output layer and the set process requirement meet the set requirement.

After step S303, the method further includes:
determining whether the difference degree between the process result evaluation index adjusted through step S303 and the set process requirement meets the set requirement. If yes, proceed to step S304, and if not, proceed to step S306.

At S304, if another process result evaluation index that has a difference degree with the set process requirement not meeting the set requirement exists in the other process result evaluation indices, step S301 to step S303 are repeated until all the process evaluation indices in the output layer meet the set process requirement, and a feature value of each process parameter in the intermediate layer is determined.

At S305, based on the feature value of each process parameter in the intermediate layer obtained in step S304, along the output layer to the input layer, the feature value of each process parameter in the outer intermediate layers and the values of the process parameters in the input layer are continued to be optimized layer by layer using the gradient algorithm and the self-consistent iterative method, until the process parameter set in the input layer is obtained to make all process result evaluation indices output by the deep neural network model meet the set process requirement.

At S306, the process parameter corresponding to the weight item with the largest value adjusted and optimized in step S303 is kept unchanged, a process parameter having a second largest value in the weight item related to the adjusted process result evaluation index corresponding to step S303 is determined in the intermediate layer neighboring to the output layer.

At S307, the value of the weight item of the process parameter with the second largest value in the weight item is kept unchanged, and the feature value of the process parameter with the second largest numerical value in the weight item is optimized and adjusted using the gradient algorithm until the difference degree between the process result evaluation index adjusted corresponding to step S303 in the output layer and the corresponding set process requirement meets the set requirement.

In some embodiments, after step S303, step S304 can be directly executed without determining whether the difference degree between the adjusted process result evaluation index in step S303 and the set process requirement meets the set requirement, and step S306 and step S307 can be omitted.

In some embodiments, after step S305, the method further includes:

at S308, if a process result evaluation index having the difference degree with the set process requirement not meeting the set requirement still exists in the output layer after optimizing and adjusting all the process parameters related to the process result evaluation index,

selecting process parameters that cause the sum of squares of the different degrees between the process result evaluation indices and the set process requirement to be minimum to form a new process parameter set, and using the new process parameter set as the process recipe for performing the actual process.

In embodiments of the present disclosure, the calculation equation of the gradient algorithm is:

$$x_i = x_i - \theta \times (\partial y / \partial x_i)$$

where $x_i$ denotes the adjusted process parameter in the intermediate layer, y denotes the adjusted process result evaluation index, and $\theta$ denotes the adjustment step size.

In a specific implementation process from step S301 to step S308, the process result evaluation index y output by the output layer of the deep neural network model is first compared with the process requirement $y_{actual}$, if the set requirement is not met, according to the output difference degree $\Delta = |(y - y_{actual}) / y_{actual}|$ between the process result evaluation index y and the process requirement $y_{actual}$, a process result evaluation index having the largest difference degree with the set process requirement can be determined. According to the value w of the weight item of the process parameter set corresponding to the process result evaluation index, and according to a process parameter $x_i$ of the process parameter set corresponding to the largest value in the weight item can be adjusted according to the gradient algorithm $x_i = x_i - \theta \times (\partial y / \partial x_i)$, where $\theta$ is the step size, and so on to repeat, until self-consistency is achieved. That is, the process result obtained by the deep neural network model with the provided process parameters can be nearly consistent with the process requirement (the process result evaluation index output reaches 95% of the set process requirement, with a range between 90% and 100%).

If the process requirement is not met after the process parameters with the largest values in the weight item are traversed using the gradient algorithm, a process parameter with the largest value in the weight item adjusted and optimized in S303 can be kept unchanged, the feature value of the process parameter with the second largest value in the weight item can be optimized using the gradient algorithm, and so on. If the process requirement is not met after all the process parameters are traversed, the actual process can be performed according to the process parameter with the sum of squares of the difference degree Δ between the process result evaluation index y and the process requirement $y_{actual}$ for all the process result evaluation indices being minimum. That is, process parameters that cause the sum of the squares of the difference degrees between the process result evaluation indices and the set process requirement to be minimum can form a new process parameter set. The new process parameter set can be used as the process recipe for the actual process.

Taking the etching machine as an example, the process of the optimal solution of the self-consistency method is further described.

First, a process parameter set of the process recipe can be used randomly. A process result can be obtained at the output layer after inputting the process parameter set into the deep neural network model. Then, a process result evaluation index having the largest difference with the set process requirement can be determined in the process result. For example, assume that the sidewall angle has the largest difference, an item in a previous deep neural network layer having the largest weight related to the sidewall angle can be then determined. Then, the value of the weight item can be kept unchanged, and the value of the weight item can be adjusted step by step according to the gradient algorithm until the sidewall angle meets the requirement (e.g., achieved 95% of the set value). Then, the other process result evaluation indices output by the model may change too. If the other process result evaluation indices also exceed the set process requirement, the process result evaluation indices can be optimized according to a method similar to the above method until all the process result evaluation indices meet the set process requirement. Meanwhile, feature values of the process parameters of the intermediate layer neighboring to the value set of the process result evaluation indices can also be obtained. the feature values of the process parameters of the intermediate layer can be optimized in a similar method, and so on, until the data of the above process parameter set of the input layer at the most left side in FIG. 4, i.e., in the process recipe, is obtained.

Embodiments of the present disclosure further provide a semiconductor process recipe automatic acquisition system, including:

   a deep neural network model, the deep neural network model being formed by a plurality of trained deep neural network layers, and the deep neural network model being able to output accurate process result evaluation indices corresponding to the process parameter set based on the input process parameter set; and
   a computation module configured to perform the semiconductor process recipe acquisition method of embodiments of the present disclosure.

The present disclosure further provides semiconductor process equipment, including the semiconductor process recipe acquisition system of embodiments of the present disclosure.

In the solution of the present disclosure, the process recipe can be automatically provided by the software according to the process requirement to improve the automatic degree of the etching machine. That is, the process evolves from the process engineer inputs and repeatedly adjusts the process parameters based on experience to directly input the process requirement. Then, the software can provide the corresponding process recipe.

The present disclosure is further described through the following specific embodiments.

Specific embodiments

The present disclosure can be applied to an etching machine. The specific process can be realizing an etching process with a critical dimension of 3 micrometers. The etching process with the critical dimension of 3 micrometers is shown in FIG. 5.

The etching pattern may need to use a Bosch process. Thus, the plurality of process parameters $x_i$ of the process parameter set can include a deposition step chamber pressure, a deposition step upper electrode center power, a deposition step lower electrode edge power, a deposition step center $C_4F_8$ flowrate, a deposition step edge $C_4F_8$ flowrate, deposition step starting time, deposition step ending time, an etching step chamber pressure, an etching step upper electrode center power, an etching step lower electrode edge power, an etching step lower electrode starting power, an etching step lower electrode ending power, an etching step center $C_4F_8$ flowrate, an etching step edge $C_4F_8$ flowrate, etching step starting time, and etching step ending time. The process result evaluation index y can include an etching depth, an upper opening dimension, a lower opening dimension, a selection ratio, an upper sidewall roughness (a scallop size), and a lower sidewall roughness (a scallop size).

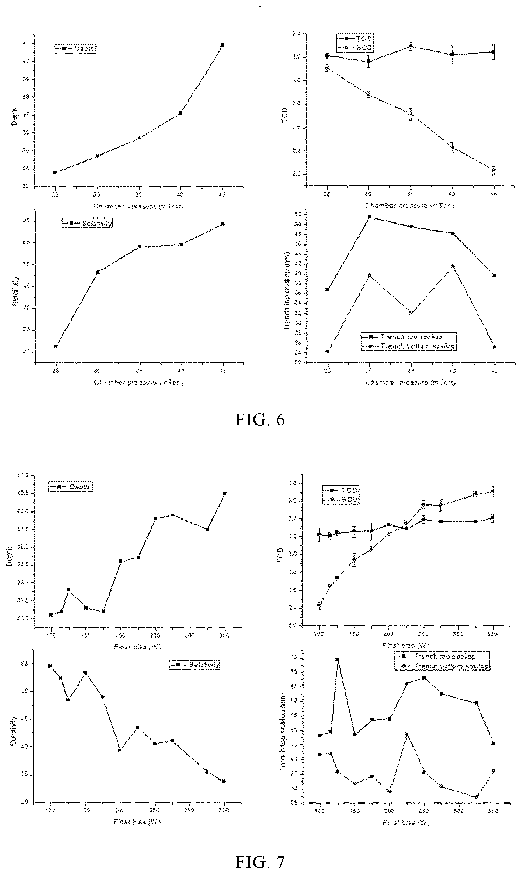

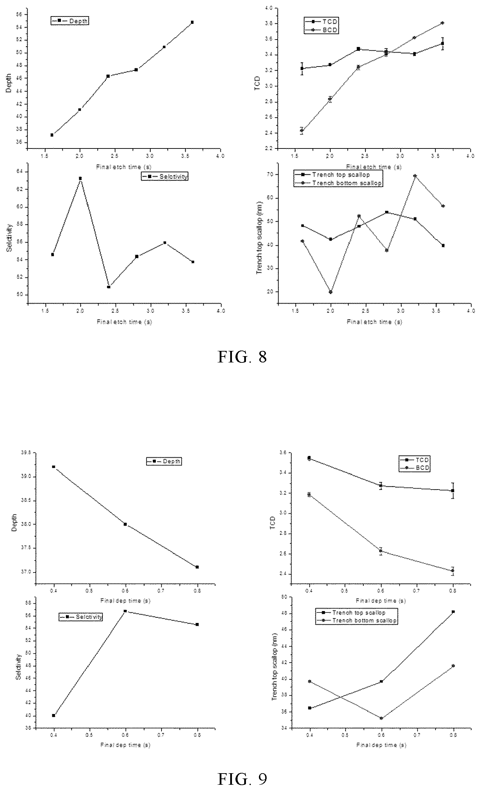

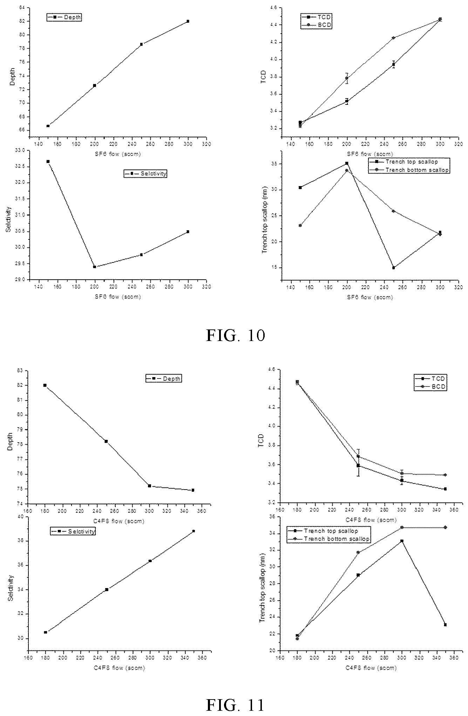

Taking groove etching as an example, the deep neural network model of embodiments of the present disclosure is trained according to the process data shown in FIG. 6 to FIG. 11.

A trend of values of the weight item of the model function trained based on the process data shown in FIG. 6 to FIG. 11 is as follows.

The chamber pressure has relatively strong relevance with the etching topography, and the value of the weight item is relatively large. The lower electrode ending power (i.e., Bias) has relatively strong relevance with the etching topography, and the value of the weight item is relatively large.

It needs to be noted that, in addition to the process database established in embodiments of the present disclosure, the process trend of the process database is also reported in various documents. Thus, the corresponding process database can also be established by reading the documents.

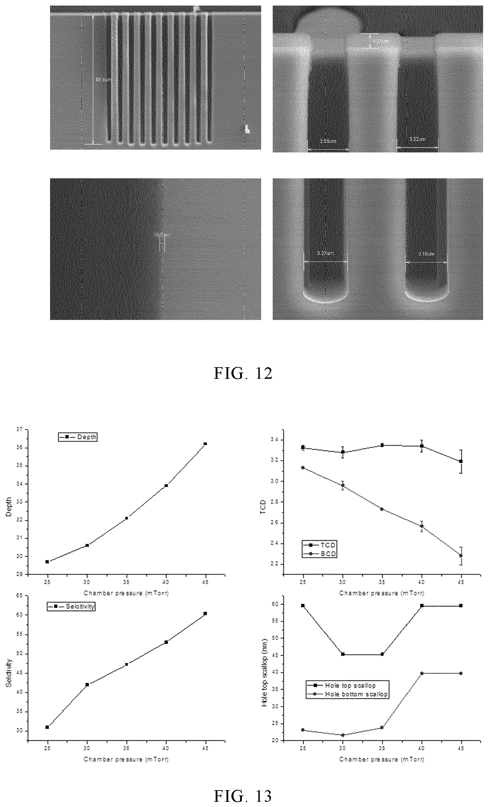

After the model is trained, the process recipe meeting the process requirement can be reverse-engineered according to the process result shown in FIG. 12 through a recursive and iterative method. When performing reverse-engineering on the etching angle, since the etching angle has relatively strong relevance (weight) with the lower electrode ending power and the etching ending single step time, in the solution of the present disclosure, the two process parameters can be optimized using the gradient algorithm to obtain the process recipe shown in Table 1.

Table 1 Etching process recipe

| Process step | Pressure (mTorr) | upper electrode center power (W) | upper electrode edge power (W) | Lower electrode power* (W) | Center $SF_6$ flowrate (sccm) | Edge $SF_6$ flowrate (sccm) | Center $C_4F_8$ flowrate (sccm) | Edge $C_4F_8$ flowrate (sccm) | Single step time** (s) |
|---|---|---|---|---|---|---|---|---|---|
| Deposition step | 25 | 2000 | 600 | 1 | 0 | 0 | 350 | 50 | 0.8 - 0.4 |
| Etching step | 25 | 2000 | 600 | 100-225 | 150 | 80 | 0 | 0 | 1.6 - 2.8 |

*The lower electrode power increases from the initial value to the final value.
**The single-step time increases from the initial value to the final value.

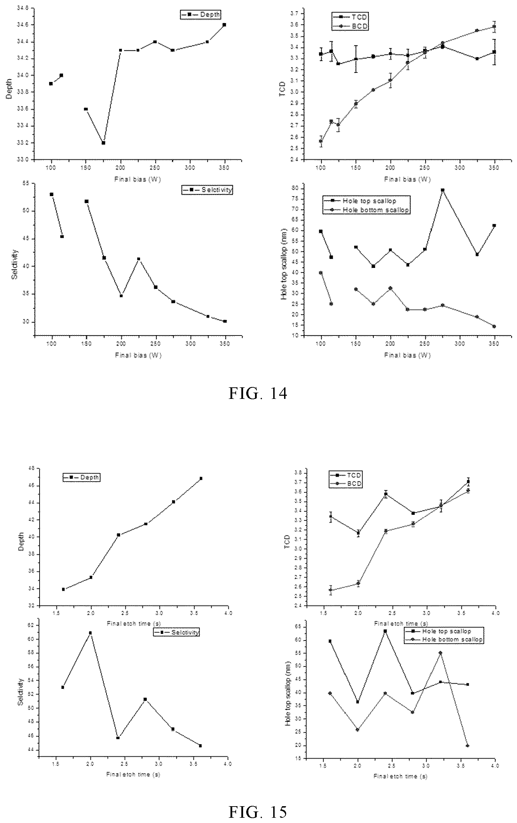

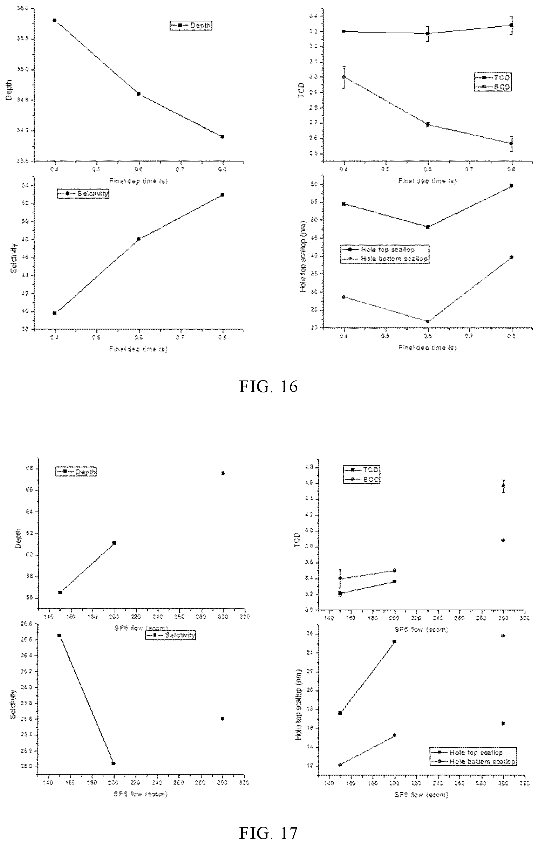

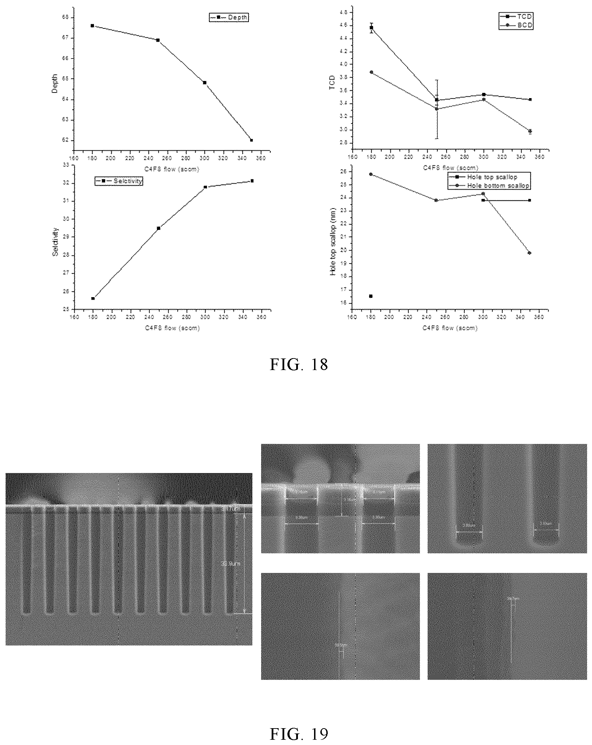

Similarly, for a hole etching process, the process databases shown in FIG. 13 to FIG. 18 are established for training the deep neural network model. After obtaining the trained model, the process recipe can be reverse-engineered according to the process result shown in FIG. 19 through the recursive iteration method and is shown in Table 2.

Table 2: Etching Process Recipe

| Process step | Pressure (mTorr) | upper electrode center power (W) | upper electrode edge power (W) | Lower electrode power (W) | Center SF$_6$ flowrate (sccm) | Edge SF$_6$ flowrate (sccm) | Center C$_4$F$_8$ flowrate (sccm) | Edge C$_4$F$_8$ flowrate (sccm) | Single step time (s) |
|---|---|---|---|---|---|---|---|---|---|
| Deposition step | 40 | 2000 | 600 | 1 | 0 | 0 | 180 | 50 | 0.8 |
| Etching step | 40 | 2000 | 600 | 100 | 300 | 80 | 0 | 0 | 1.6 |

In summary, in the solution of the present disclosure, the process recipe can be automatically provided in the etching machine according to the process result, which improves the automation degree of the machine. It needs to be noted that the present disclosure is not only suitable for the etching machine but also for the other processing processes in the semiconductor field, for example, PVD, CVD, a furnace tube, a cleaning machine, etc.

Embodiments of the present disclosure are described above. The above description is merely exemplary not exhaustive and is not limited to disclose the embodiments. Many modifications and variations can be apparent to those skilled in the art without departing from the scope and spirit of the described embodiments.

**Claims**

1. A semiconductor process recipe acquisition method comprising:

   randomly inputting a process parameter set required for a process into a constructed deep neural network model to obtain process result evaluation indices corresponding to the process parameter set, the process parameter set including a plurality of process parameters, the deep neural network model being a trained multi-layer deep neural network, the deep neural network model including an input layer, at least one intermediate layer, and an output layer, the input layer being configured to input the process parameter set, and the output layer being configured to output the process evaluation indices corresponding to the process parameter set;
   determining whether a difference degree between the process evaluation indices and corresponding set process requirements meets set requirements;
   if yes, using the process parameter set as the process recipe to perform an actual process;
   otherwise, according to the process requirements, along a direction from the output layer to the input layer, based on a gradient algorithm and a self-consistent iteration method, optimizing feature values of the at least one intermediate layer and values of the process parameters in the input layer layer by layer to optimize the values of characteristics in each middle layer and the values of each process parameter in the input layer layer by layer, until obtaining a process parameter set in the input layer that satisfies all process result evaluation indices output by the deep neural network model and meets the process requirements, and using the process parameter set that meets the process requirements as the process recipe to perform the actual process.

2. The semiconductor process recipe acquisition method according to claim 1,
   wherein a method for constructing the deep neural network model includes:

   determining a number of layers and a structure of the deep neural network model according to a number of process parameters included in the process parameter set and a number of process result evaluation indices corresponding to the process parameter set, a number of the intermediate layers being a difference between the number of process parameters and the number of process result evaluation indices, and each deep neural network layer of the deep neural network model including a plurality of neurons, along the direction from the input layer to the output layer, one neuron being reduced sequentially between neighboring deep neural networks, each neuron being connected to all neurons in a previous deep neural network layer, each process parameter being used as an input feature of a neuron in the input layer, each neuron of the intermediate layer being configured to perform calculation on output features of all neurons in a previous deep neural network layer, an output feature of each neuron in the output layer being a process result evaluation index, and the number of the process parameters included in the process parameter set being greater than the number of the process result evaluation indices corresponding to the processing parameter set; and
   determining an activation function for running the deep neural network model according to a number of layers of the deep neural network model.

3. The semiconductor process recipe acquisition method according to claim 2,
   wherein the method for constructing the deep neural network model further includes:

   using a process database as training data and training the deep neural network model using a deep learning method, the process database including historical process parameter data and historical process result data of a specific process; and
   determining a weight item and a bias item of each deep neural network layer of the deep neural network model according to a training result of the activation function.

4. The semiconductor process recipe acquisition method according to claim 3, wherein optimizing the feature values of the at least one intermediate layer and the values of the process parameters of the input layer layer by layer based on the gradient algorithm and the self-consistent iteration method includes:

step S1, finding a process result evaluation index having a largest difference degree with the process requirement in the output layer;

step S2, finding a process parameter with a largest value in the weight item related to the process result evaluation index having the largest difference degree from an intermediate layer neighboring to the output layer;

step S3, keeping a value of the weight item and a value of the bias item of the process parameter with the largest value in the weight item unchanged, using a gradient algorithm to optimize and step-adjust a feature value of the process parameter having the largest value in the weight item until a difference degree between the process result evaluation index having the largest difference degree in the output layer and the process requirement meets the set requirement;

step 4, if another process result evaluation index having a difference degree with the process requirement not meeting the set requirement exists in other process result evaluation indices, repeating step S1 to step S3 until all the process result evaluation indices in the output layer meet the process requirement, and determining a feature value of each process parameter in the intermediate layers; and

step S5, based on the feature value of each process parameter in the intermediate layer obtained in step S4, along a direction from the output layer to the input layer, continuing to use the gradient algorithm and self-consistence iteration method to optimize the feature value of each process parameter in other intermediate layers and the values of the process parameters in the input layer layer by layer, until a process parameter set causing all the process result evaluation indices output by the deep neural network model to meet the process requirement is obtained in the input layer.

5. The semiconductor process recipe acquisition method according to claim 4, further comprising, after step S3: determining whether a difference degree between the adjusted process result evaluation index through step S3 and the process requirement meets the set requirement, if yes, performing step S4, and if not, keeping the process parameter with the largest value in the weight item adjusted and optimized through step S3 and performing the following steps:

step S6, finding a process parameter with a second largest value in the weight item related to the process result evaluation index adjusted in step S3 from the intermediate layer neighboring to the output layer; and

step S7, keeping the value of the weight item of the process parameter having the second largest value in the weight item unchanged, and using the gradient algorithm to optimize and step-adjust a feature value of the process parameter having the second largest value in the weight item, until a difference degree between the process result evaluation index correspondingly adjusted in step S3 in the output layer and the process requirement meets the set requirement.

6. The semiconductor process recipe acquisition method according to claim 5, further comprising, after step 5:

step S8, if a process result evaluation index having a different degree with the process requirement not meeting the set requirement still exists in the output layer after optimizing and adjusting all the process parameters related to the process result evaluation indices,

selecting process parameters that causes a sum of squares of difference degrees between the process result evaluation indices and the process requirements to form a new process parameter set, and using the new process parameter set as a process recipe for performing an actual process.

7. The semiconductor process recipe acquisition method according to any one of claims 1 and 4-6, wherein a calculation equation of the gradient algorithm is:

$$x_i = x_i - \theta \times (\partial y / \partial x_i),$$

wherein, $x_i$ denotes the adjusted process parameter in the intermediate layer, y denotes the adjusted process result evaluation index, and $\theta$ denotes an adjustment step size.

8. The semiconductor process recipe acquisition method according to any one of claims 1 and 4-6, wherein the difference degree is calculated by:

$$\Delta = |(y - y_{actual}) / y_{actual}|,$$

wherein:

$\Delta$ denotes the difference degree between the process result evaluation index and the set process requirement, y denotes the process result evaluation index output by the deep neural network model, and $y_{actual}$ denotes the given process requirement; and
the set requirement includes the difference degree between the process result evaluation index and the corresponding set process requirement ranging between 0 and 10%.

9.  A semiconductor process recipe automatic acquisition system comprising:

a deep neural network model, the deep neural network model being a multi-layer structured deep neural network that has been trained, the deep neural network model outputting accurate process result evaluation indices corresponding to a process parameter set based on input process parameters; and
a calculation module configured to perform the semiconductor process recipe acquisition method according to any one of claims 1 to 8.

10. Semiconductor process equipment comprising the semiconductor process recipe automatic acquisition system according to claim 9.

Input layer feature    Intermediate layer    Intermediate layer      Output layer
feature          feature          feature

FIG. 1

Etch Output

Source Power    Pressure    Gas Ratio    Bias Power

FIG. 2

Input a process parameter set (including a plurality of process parameters) required by the process into the constructed deep neural network model, and obtain a process result evaluation index corresponding to the process parameter set — S101

Determine whether the difference degree between the process result evaluation indices and the corresponding set process requirement meet a set requirement — S102

Use the input process parameter set above as the process recipe of the actual process — S103

According to the set process requirement, along the direction from the above output layer to the input layer, optimize the feature values in the intermediate layers and the numerical values of the process parameters in the input layer layer by layer based on the gradient algorithm and self-consistent iterative method until obtaining a process parameter set in the input layer that can make all the process result evaluation indices output by the above deep neural network model meet the corresponding set process requirement — S104

FIG. 3A

Determine a number of layers and a structure of the deep neural network model according to a number of process parameters included in the process parameter set and a number of the processing result evaluation indices corresponding to the processing parameter set — S201

Determine the activation function of running the deep neural network model according to the number of layers of the deep neural network model — S202

Use a process database as training data to train the deep neural network model using a deep learning method — S203

Determine a weight item and a bias item of each deep neural network layer of the deep neural network model according to the training results of the activation function to finally complete the construction of the deep neural network model — S204

FIG. 3B

Determine a process result evaluation index in the output layer having the largest difference degree with the corresponding set process requirement — S301

Determine a process parameter having a largest value in a weight item related to the process result evaluation index having the largest difference degree from the intermediate layer neighboring to the output layer — S302

Keep the value of the weight term and the value of the bias term of the process parameter having the largest value in the weight item unchanged, and the feature value of the process parameter having the largest value in the weight item is adjusted using the gradient algorithm until the difference degree between the process result evaluation index having the largest difference degree in the output layer and the set process requirement meet the set requirement — S303

Determine whether the difference degree between the process result index adjusted in S303 and the set process requirement

**Yes**

If another process result evaluation index that has a difference degree with the set process requirement not meeting the set requirement exists in the other process result evaluation indices, repeat step S301 to step S303 until all the process evaluation indices in the output layer meet the set process requirement, and a feature value of each process parameter in the intermediate layer is determined. — S304

Based on the feature value of each process parameter in the intermediate layer obtained in step S304, along the output layer to the input layer, continue to optimize the feature value of each process parameter in the outer intermediate layers and the values of the process parameters in the input layer layer by layer using the gradient algorithm and the self-consistent iterative method, until the process parameter set in the input layer is obtained to make all process result evaluation indices output by the deep neural network model meet the set process requirement — S305

If a process result evaluation index having the difference degree with the set process requirement not meeting the set requirement still exists in the output layer after optimizing and adjusting all the process parameters related to the process result evaluation index, select process parameters that cause the sum of squares of the different degrees between the process result evaluation indices and the set process requirement to be minimum to form a new process parameter set, and using the new process parameter set as the process recipe for performing the actual process — S308

**No**

Keep the process parameter corresponding to the weight item with the largest value adjusted and optimized in step S303 unchanged, a process parameter having a second largest value in the weight item related to the adjusted process result evaluation index corresponding to step S303 is determined in the intermediate layer neighboring to the output layer — S306

Keep the value of the weight item of the process parameter with the second largest value in the weight item unchanged, and optimize and adjust the feature value of the process parameter with the second largest numerical value in the weight item the gradient algorithm until the difference degree between the process result evaluation index adjusted corresponding to step S303 in the output layer and the corresponding set process requirement meets the set requirement — S307

FIG. 3C

Start

Determine a number of neural network layers according to the number of the process parameters and the process evaluation index

Provide the activation function

Training the model function according to the process database (the existing technology 2)

Determine a weight item and a bias item of each deep neural network layer

Input process requirement

Randomly provide a process parameter set

Predict whether the current parameter meets the requirement according to the model — N

Execute the process according to the process parameter

Test the process result

Whether the current process satisfy the predetermined process requirement — N → Process engineer fine adjusts the process parameter

Y

End

Use the gradient algorithm to adjust the feature value of a process parameter with a second largest value in weight item to obtain a new process parameter set

N

Whether all process parameters are traversed? — Y

Y

Whether the current process parameter is traversed? — N

Use the gradient algorithm to adjust the process parameter to obtain a new process parameter set

Find the process parameter with the largest value in weight item

Calculate which process requirement has the largest difference degree

Select the process parameters causing the sum of squares of different degrees between the process result evaluation indices and the process requirement to obtain the new process parameter set

Perform the process according to the new process parameter set

Test the process result

FIG. 3D

Chamber pressure

Upper electrode power

Lower electrode power

SF$_6$ flowrate

O$_2$ flowrate

Etching Time

Etching depth

Sidewall angle

Etching speed

Process parameter    Intermediate layer feature    Intermediate layer feature    Intermediate layer feature

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

## INTERNATIONAL SEARCH REPORT

| International application No. |
| --- |
| **PCT/CN2022/128199** |

**A. CLASSIFICATION OF SUBJECT MATTER**

G06Q 10/06(2012.01)i; G06N 3/08(2006.01)i; G06N 3/04(2006.01)i; G06F 30/27(2020.01)i; H01L 21/67(2006.01)i

According to International Patent Classification (IPC) or to both national classification and IPC

**B. FIELDS SEARCHED**

Minimum documentation searched (classification system followed by classification symbols)

G06Q; G06N; G06F; H01L

Documentation searched other than minimum documentation to the extent that such documents are included in the fields searched

Electronic data base consulted during the international search (name of data base and, where practicable, search terms used)

CNABS, ENTXTC, CJFD, CNTXT, CNKI, DWPI, WPABS, ENTXT, IEEE, Patentics: 半导体, 工艺, 参数, 深度神经网络, 评价指标, 输入层, 中间层, 隐藏层, 隐含层, 输出层, 判断, 比较, 阈值, 梯度, 自治迭代, 优化; semiconductor, parameter?, deep neural network model, judg+, differenc+, gradient algorithm, self-consistent, iteration, input, output, hidden, middle layer

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114091848 A (BEIJING NAURA MICROELECTRONICS EQUIPMENT CO., LTD.) 25 February 2022 (2022-02-25)<br>description, paragraphs 78-124, and figures 1-4 | 1-10 |
| X | CN 110262233 A (JIANGSU UNIVERSITY) 20 September 2019 (2019-09-20)<br>description, paragraphs 55-99 | 1, 7-10 |
| A | CN 113569352 A (HUAZHONG UNIVERSITY OF SCIENCE AND TECHNOLOGY) 29 October 2021 (2021-10-29)<br>entire document | 1-10 |
| A | CN 113553762 A (DONGFENG MOTOR GROUP CO., LTD.) 26 October 2021 (2021-10-26)<br>entire document | 1-10 |
| A | CN 109726810 A (SAMSUNG ELECTRONICS CO., LTD.) 07 May 2019 (2019-05-07)<br>entire document | 1-10 |
| A | US 2021089893 A1 (SEOUL NATIONAL UNIVERSITY R&DB FOUNDATION et al.) 25 March 2021 (2021-03-25)<br>entire document | 1-10 |

☑ Further documents are listed in the continuation of Box C.    ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **28 December 2022** | **20 January 2023** |

| Name and mailing address of the ISA/CN | Authorized officer |
| --- | --- |
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| | International application No. |
|---|---|
| | **PCT/CN2022/128199** |

**C.    DOCUMENTS CONSIDERED TO BE RELEVANT**

| Category* | Citation of document, with indication, where appropriate, of the relevant passages | Relevant to claim No. |
|---|---|---|
| A | US 2005199341 A1 (TOKYO ELECTRON LTD.) 15 September 2005 (2005-09-15)<br>    entire document | 1-10 |

Form PCT/ISA/210 (second sheet) (January 2015)

**INTERNATIONAL SEARCH REPORT**
Information on patent family members

| | International application No. |
|---|---|
| | **PCT/CN2022/128199** |

| Patent document cited in search report | | | Publication date (day/month/year) | Patent family member(s) | | | Publication date (day/month/year) |
|---|---|---|---|---|---|---|---|
| CN | 114091848 | A | 25 February 2022 | None | | | |
| CN | 110262233 | A | 20 September 2019 | None | | | |
| CN | 113569352 | A | 29 October 2021 | None | | | |
| CN | 113553762 | A | 26 October 2021 | None | | | |
| CN | 109726810 | A | 07 May 2019 | US | 2019129297 | A1 | 02 May 2019 |
| | | | | DE | 102018117836 | A1 | 02 May 2019 |
| | | | | KR | 20190048491 | A | 09 May 2019 |
| | | | | JP | 2019083306 | A | 30 May 2019 |
| | | | | US | 10691016 | B2 | 23 June 2020 |
| | | | | JP | 6744366 | B2 | 19 August 2020 |
| US | 2021089893 | A1 | 25 March 2021 | WO | 2020141858 | A1 | 09 July 2020 |
| | | | | KR | 101991041 | B1 | 19 June 2019 |
| US | 2005199341 | A1 | 15 September 2005 | CN | 1682338 | A | 12 October 2005 |
| | | | | WO | 2004032194 | A2 | 15 April 2004 |
| | | | | KR | 20050054985 | A | 10 June 2005 |
| | | | | JP | 2006501684 | A | 12 January 2006 |
| | | | | TW | 200419631 | A | 01 October 2004 |
| | | | | AU | 2003279058 | A8 | 23 April 2004 |
| | | | | WO | 2004032194 | A3 | 15 July 2004 |
| | | | | AU | 2003279058 | A1 | 23 April 2004 |
| | | | | TW | I264043 | B | 11 October 2006 |
| | | | | CN | 100353485 | C | 05 December 2007 |
| | | | | KR | 101027183 | B1 | 05 April 2011 |

Form PCT/ISA/210 (patent family annex) (January 2015)